# EUROPEAN PATENT APPLICATION

(11) **EP 4 227 986 A1**
(43) Date of publication of application: **16.08.2023**
(21) Application number: 22156054.3
(22) Date of filing: 10.02.2022
(51) Int. Cl.: H01L 23/055, H01L 23/053, H01L 23/16, H01L 25/07

(54) **POWER SEMICONDUCTOR MODULE ARRANGEMENT AND METHODS FOR PRODUCING A SEMICONDUCTOR ARRANGEMENT**

(71) Applicant: Infineon Technologies AG, 85579 Neubiberg (DE)
(72) Inventor: LASSMANN, Matthias, 59555 Lippstadt (DE); ARENS, Andre, 59602 Ruethen (DE); BOENIG, Guido, 59581 Warstein (DE); LUDWIG, Marco, 58739 Wickede (DE)
(74) Representative: Westphal, Mussgnug & Partner, Patentanwälte mbB

(57) **Abstract**

A power semiconductor module arrangement comprises a housing (7), a substrate (10) arranged inside the housing (7), a printed circuit board (81) arranged inside the housing (7) distant from and in parallel to the substrate (10), an encapsulant (5) at least partly filling the interior of the housing (7), thereby covering the substrate (10) and the printed circuit board (81), and a heat protective layer (52) arranged inside the housing (7) between the substrate (10) and the printed circuit board (81), and extending in a plane that is parallel to the substrate (10) and the printed circuit board (81), wherein a thermal resistance of the heat protective layer (52) is greater than a thermal resistance of the encapsulant (5).

## Description

### TECHNICAL FIELD

The instant disclosure relates to a semiconductor module arrangement and to methods for producing a semiconductor arrangement, in particular to a semiconductor module arrangement comprising a printed circuit board.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

Power semiconductor module arrangements often also include a printed circuit board arranged distant from and in parallel to the substrate. The printed circuit board may also be arranged inside the housing. Additional printed circuit boards could also be arranged outside the housing. The power semiconductor module arrangement generally further includes an encapsulant. The encapsulant may at least partly fill the interior of the housing, thereby covering the substrate, the components and electrical connections that are arranged on the substrate, as well as the printed circuit board that is arranged inside the housing and any elements mounted thereon in order to protect the different elements from certain environmental conditions and mechanical damage. However, there is a risk that heat generated by the components arranged on the substrate is transferred to the printed circuit board via the encapsulant such that elements arranged on the printed circuit board may be unintentionally heated, which may lead to a malfunctioning or even a complete failure of the power semiconductor module arrangement.

There is a need for a power semiconductor module arrangement in which a printed circuit board arranged inside the housing is protected from being overheated by heat generated by the elements arranged on the substrate while, at the same time, being sufficiently protected from environmental conditions and mechanical damage.

### SUMMARY

A power semiconductor module arrangement includes a housing, a substrate arranged inside the housing, a printed circuit board arranged inside the housing distant from and in parallel to the substrate, an encapsulant at least partly filling the interior of the housing, thereby covering the substrate and the printed circuit board, and a heat protective layer arranged inside the housing between the substrate and the printed circuit board, and extending in a plane that is parallel to the substrate and the printed circuit board, wherein a thermal resistance of the heat protective layer is greater than a thermal resistance of the encapsulant.

A method includes arranging a substrate in a housing, arranging a heat protective layer in the housing, arranging a printed circuit board in the housing distant from and in parallel to the substrate, and forming an encapsulant at least partly filling the interior of the housing, thereby covering the substrate, the printed circuit board, and the heat protective layer, wherein the heat protective layer is arranged between the substrate and the printed circuit board, and extends in a plane that is parallel to the substrate and the printed circuit board, and a thermal resistance of the heat protective layer is greater than a thermal resistance of the encapsulant.

Another method includes arranging a substrate in a housing, arranging a printed circuit board in a housing, distant from and in parallel to the substrate, filling a first material in the housing, thereby covering the substrate and any components mounted thereon with the first material, wherein a height of the material from the substrate in a vertical direction is less than a distance between the substrate and the printed circuit board, hardening the first material, thereby forming a first section of an encapsulant, turning the arrangement upside down, filling the first material in the housing, thereby covering a top or lid of the housing and the printed circuit board with the first material, wherein the housing is not completely filled with the first material such that a layer of air remains between the first section of the encapsulant and the first material, hardening the first material, thereby forming a second section of encapsulant, wherein the layer of air between the two sections of encapsulant forms a heat protective layer having a thermal resistance that is greater than a thermal resistance of the encapsulants.

Another method includes arranging a substrate in a housing, filling a first material in the housing, thereby covering the substrate and any components mounted thereon, arranging a printed circuit board in the housing, distant from and in parallel to the substrate, wherein the printed circuit board comprises protrusions extending along the edges of the printed circuit board, and wherein arranging the printed circuit board in the housing comprises pressing the printed circuit board into the first material, with the protrusions facing towards the substrate such that a layer of air remains below the printed circuit board, and hardening the first material, thereby forming an encapsulant, wherein the layer of air below the printed circuit board forms a heat protective layer having a thermal resistance that is greater than a thermal resistance of the encapsulant.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of another power semiconductor module arrangement.
Figure 3 is a cross-sectional view of a power semiconductor module arrangement according to one example.
Figure 4 is a cross-sectional view of a power semiconductor module arrangement according to another example.
Figure 5 schematically illustrates a top view of a heat protective layer in a power semiconductor module arrangement.
Figure 6 schematically illustrates a cross-sectional view of a power semiconductor module arrangement along a section line A - A' as indicated in Figure 5.
Figure 7 schematically illustrates a top view of an exemplary heat protective layer in a power semiconductor module arrangement.
Figure 8 schematically illustrates a cross-sectional view of a power semiconductor module arrangement along a section line B - B' as indicated in Figure 7.
Figure 9, including Figures 9A and 9B, schematically illustrates a method for forming a heat protective layer according to one example.
Figure 10 is a cross-sectional view of a power semiconductor module arrangement according to another example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

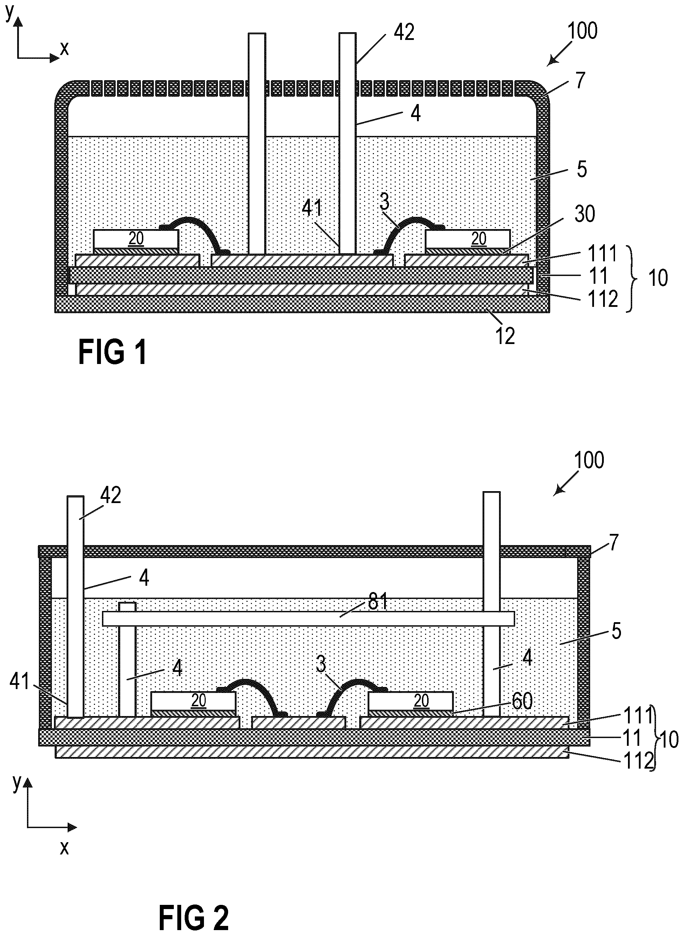

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This is, however, only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example. For example, the second ends 42 of the terminal elements 4 may be connected to a printed circuit board (not illustrated in Figure 1).

The power semiconductor module arrangement 100 further includes an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 42, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

Now referring to Figure 2, another power semiconductor module arrangement 100 is schematically illustrated. The power semiconductor module arrangement 100 of Figure 2 essentially corresponds to the power semiconductor module arrangement 100 that has been explained with respect to Figure 1 above. However, the power semiconductor module arrangement 100 illustrated in Figure 2 further comprises a printed circuit board 81. The printed circuit board 81 is coupled to a first subset of the terminal elements 4 and is arranged inside the housing 7. The first subset of the terminal elements 4 may comprise shorter terminal elements that are arranged entirely inside the housing 7. The first subset of the terminal elements 4, however, may also extend from the substrate 10 through a through hole in the printed circuit board 81 to the outside of the housing 7, which is exemplarily illustrated for one of the terminal elements 4 of Figure 2. A second, optional subset of the terminal elements 4, may extend from the substrate 10 to the outside of the housing 7, without contacting the printed circuit board 81 in any way (see terminal element 4 on the far left side of Figure 2).

According to another example that is not specifically illustrated, one or more terminal elements 4 may be mechanically and electrically coupled to the printed circuit board 81 with their first ends 41, while their second end 42 extends to the outside of the housing 7. By arranging a printed circuit board 81 inside the housing 7, the power semiconductor module arrangement 100 can be implemented in a compact and space saving way, for example. This is, because at least a subset of a plurality of components that is usually arranged on the substrate 10 or on an external printed circuit board (printed circuit board that is arranged outside of the housing 7) can be arranged on the printed circuit board 81 instead of on the substrate 10 or on an external printed circuit board. That is, some (or all) components can be arranged on the printed circuit board 81 inside the housing 7, while others (or none) are arranged on an (optional) external printed circuit board. The size of the substrate 10 and/or an external printed circuit board, therefore, can be reduced as compared to arrangements only comprising a substrate 10, or a substrate 10 and an external printed circuit board outside the housing 7 but not the printed circuit board 81 inside the housing 7.

In order to protect the printed circuit board 81 inside the housing 7 and the components arranged on the printed circuit board 81 from certain environmental conditions and mechanical damage, the printed circuit board 81 may also be covered by the encapsulant 5 that has been described with respect to Figure 1 above. During the use of the power semiconductor module arrangement 100, the elements arranged on the substrate 10 and on the printed circuit board 81 generate heat. In some cases, the elements arranged on the substrate 10 may generate significantly more heat than the elements arranged on the printed circuit board 81. Therefore, elements that withstand higher temperatures may be arranged on the substrate 10, while the elements arranged on the printed circuit board 81 may withstand only lower temperatures. There is a risk, however, that heat generated by the elements arranged on the substrate 10 is transferred through the encapsulant 5 to the printed circuit board 81. In this way, the elements on the printed circuit board 81 may be heated unintentionally, which may lead to a malfunctioning or even to a complete failure of the power semiconductor module arrangement 100.

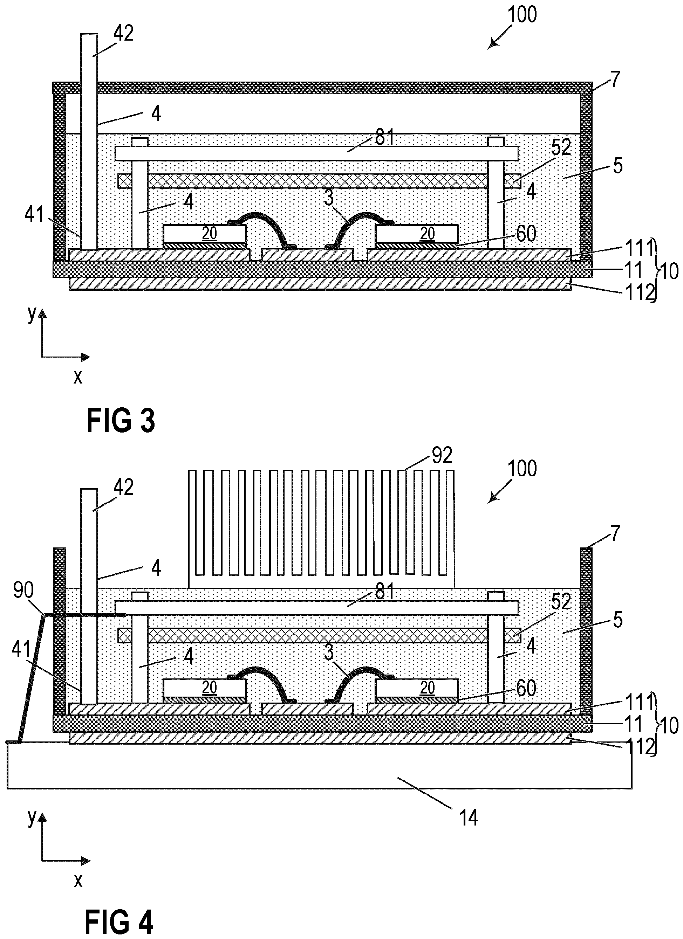

According to one example, which is schematically illustrated in Figure 3, a heat protective layer 52 is arranged inside the housing 7 between the substrate 10 and the printed circuit board 81. The heat protective layer 52 extends in a plane that is parallel to the substrate 10 and the printed circuit board 81. A thermal resistance of the heat protective layer 52 is greater than a thermal resistance of the encapsulant 5. In this way, less heat in transferred from the substrate 10 to the printed circuit board 81, as the heat protective layer 52 reduces the heat conduction from the substrate 10 to the printed circuit board 81. The heat protective layer 52 may be formed by a cavity in the encapsulant 5 that is filled with air, for example. The specific thermal resistance R of a material is 1/λ (R = 1/λ), wherein λ is the thermal conductivity of a material. The thermal conductivity λ of air, for example, is 0.0262 W/mK. Silicone gels or other materials that may be used for the encapsulant 5, on the other hand, may have a thermal conductivity λ of between 1 and 4 W/mK, for example, resulting in a significantly lower specific thermal resistance R. However, the heat protective layer 52 may be formed by any other suitable material which has a greater thermal resistance than the material of the encapsulant 5.

In the example illustrated in Figure 3, the heat protective layer 52 is arranged distant from the substrate 10 and distant from the printed circuit board 81. That is, the heat protective layer 52 is fully embedded in the encapsulant 5 and directly adjoins the encapsulant 5 on all sides. In the example illustrated in Figure 3, the heat protective layer 52 extends over the full length of the printed circuit board 81. This, however, is only an example. The size and form of the heat protective layer 52 may depend on several different factors. For example, a heat protective layer 52 may only be arranged in areas above the substrate 10, where heat generating devices are arranged. That is, the heat protective layer 52 may be omitted, for example, in areas above the substrate 10 where no significant heat is generated during the use of the power semiconductor module arrangement 100. This requires an exact knowledge about the devices and areas which generate heat during the use of the power semiconductor module arrangement. Therefore, arranging the heat protective layer 52 over the entire size of the printed circuit board 81 may be considered in order to ensure that the printed circuit board 81 is protected from heat generated by the substrate 10 even if it is not known in which areas of the substrate 10 significant heat is generated.

The heat protective layer 52 may have a thickness in the vertical direction y which is less than a thickness of the encapsulant 5 in the same direction y. In this way, the heat protective layer 52 can be fully embedded in the encapsulant 5.

In addition to the heat protective layer 52, the power semiconductor module arrangement 100 may include further heat protective devices. According to one example, the power semiconductor module arrangement 100 may further comprise at least one heat conduction element 90 coupled to the printed circuit board 81 with a first end, and to a first heat sink 14 with a second end. The substrate 10 may be arranged on the first heat sink 14, and the at least one heat conduction element 90 may be configured to conduct heat away from the printed circuit board 81 to the first heat sink 14. Additionally or alternatively, the power semiconductor module arrangement 100 may comprise at least one second heat sink 92 thermally coupled to the printed circuit board 81 and configured to conduct heat away from the printed circuit board 81, wherein the printed circuit board 81 is arranged between the at least one second heat sink 92 and the substrate 10. An arrangement comprising a heat conduction element 90 and a second heat sink 92 is exemplarily illustrated in Figure 4. Only one heat conduction element 90 is exemplarily illustrated in Figure 4. The arrangement, however, may also comprise more than one heat conduction element 90. The second heat sink 92 in the arrangement of Figure 4 does not directly contact the printed circuit board 81. The printed circuit board 81, as has been described above, is embedded in the encapsulant 5. A layer of the encapsulant 5, therefore, may be arranged between the printed circuit board 81 and the heat sink 92. The material of the encapsulant 5, as has been described above, generally has a comparably good thermal conductivity. Therefore, heat can be conducted away from the printed circuit board 81 through the encapsulant 5 to the second heat sink 92. It is, however, also possible to arrange a layer of a material between the printed circuit board 81 and the second heat sink 92 that has a higher thermal conductivity than the material of the encapsulant 5. In this way, the heat dissipation from the printed circuit board 81 to the second heat sink 92 can be further increased. For example, a layer of a highly thermal conducting glue may be arranged between the printed circuit board 81 and the second heat sink 92.

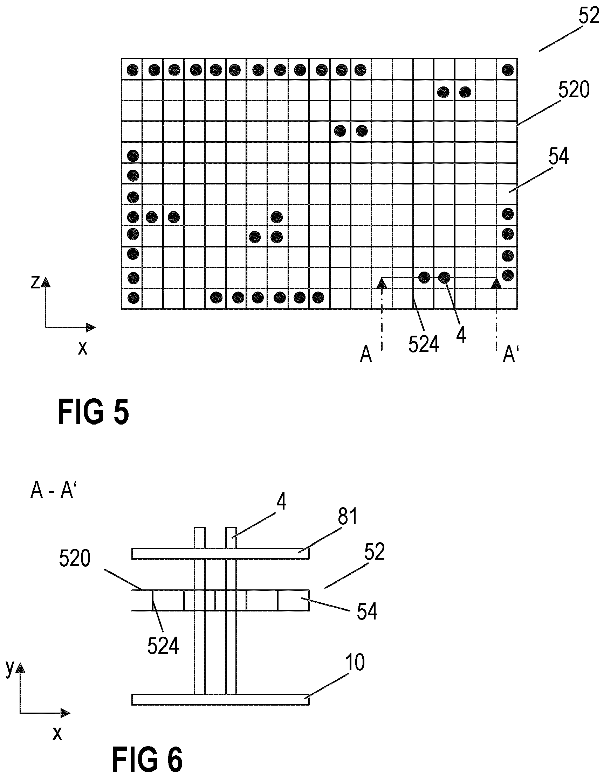

Now referring to Figure 5, one example of a heat protective layer 52 is schematically illustrated. Figure 5 schematically illustrates a top view of an exemplary heat protective layer 52. The heat protective layer 52 in this example may be formed by a cavity filled with air. The cavity is surrounded by a casing 520 comprising a material that is different from the material of the encapsulant 5 (e.g., a material having a higher thermal resistivity than the encapsulant 5 and is hard enough to form a stable casing 520 and soft enough such that the terminal elements 4 may pierce through the casing 520). That is, the casing 520 may comprise a top surface, a bottom surface and side surfaces extending from the bottom surface to the top surface, in order to fully enclose the cavity. The cavity may be partitioned into a plurality of separate chambers 54 by means of a plurality of dividing walls 524. The dividing walls 524 and resulting chambers 54 are also visible in the cross sectional view of Figure 6 along a section-line A - A' of the arrangement illustrated in Figure 5. As has been described above, the arrangement may further comprise terminal elements 4 extending from the substrate 10 to the printed circuit board 81. Such terminal elements 4 may extend through the heat protective layer 52. In particular, each of a plurality of terminal elements 4 may extend through a different one of the plurality of chambers 54 of the heat protective layer 52. That is, some chambers 54 may be penetrated by one of the terminal elements 4. In particular, the top surface and the bottom surface of the respective chambers 54 may be pierced by the respective terminal elements 4 while the dividing walls 524 remain intact. In this way, all chambers 54 that are not penetrated by a terminal element 4 remain completely intact and provide an unobstructed barrier for heat generated on the substrate 10. All chambers 54 that are penetrated by a terminal element 4, however, are still at least partly filled with air and also provide a barrier for heat generated on the substrate 10. However, as the top and bottom surface of these chambers are pierced by the terminal elements 4, material of the encapsulant 5 may leak into the concerned chambers 54, which may reduce the protective function of the heat protective layer 52 to a certain degree. This, however, generally is acceptable, as a large number of chambers 54 generally remains intact.

A heat protective layer 52 as has been described with respect to Figures 5 and 6 may be produced independently and may be easily inserted into the power semiconductor module arrangement. The heat protective layer 52, for example, may be provided as a kind of mat, which may be inserted into the power semiconductor module arrangement 100. The heat protective layer 52 of this example does not have to be specifically adapted to any specific arrangement of the terminal elements 4. In different arrangements, different chambers 54 of the heat protective layer 52 may be penetrated. One and the same heat protective layer 52, however, may be used for different designs and arrangements. The heat protective layer 52 may have a rectangular or square shape, for example. The shape of the heat protective layer 52, for example, may be similar to the shape of the corresponding printed circuit board 81. The size of the heat protective layer 52 may also be identical or similar to the size of the printed circuit board 81, in order to provide sufficient heat protection. The dividing walls 524, however, are generally optional. It is also possible that a single continuous chamber or cavity filled with air is surrounded by the casing 520. The terminal elements 4 may penetrate through the top surface and the bottom surface in a similar way, as has been described with respect to Figures 5 and 6. In such an arrangement, however, the heat protective function of the heat protective layer 52 may be reduced to a higher degree, as material of the encapsulant 5 may enter the cavity through the openings resulting from piercing the terminal elements 4 through the heat protective layer 52 and is not held back by any dividing walls 524.

The heat protective layer 52 of Figures 5 and 6, however, is only one example. According to another example, a mat or layer of any suitable material (e.g., glass or plastic material) may be formed and inserted in the power semiconductor module arrangement. The heat protective layer 52, for example, may be formed by any material having a thermal resistance that is greater than a thermal resistance of the encapsulant 5. At the same time, the material may be chosen such that it is possible to penetrate through the heat protective layer 52 with the terminal elements 4. According to one example, a heat protective layer 52 comprises a material, e.g., the same material as the encapsulant 5, and a plurality of particles or fillers distributed therein and having a higher thermal resistivity than the material of the encapsulant 5.

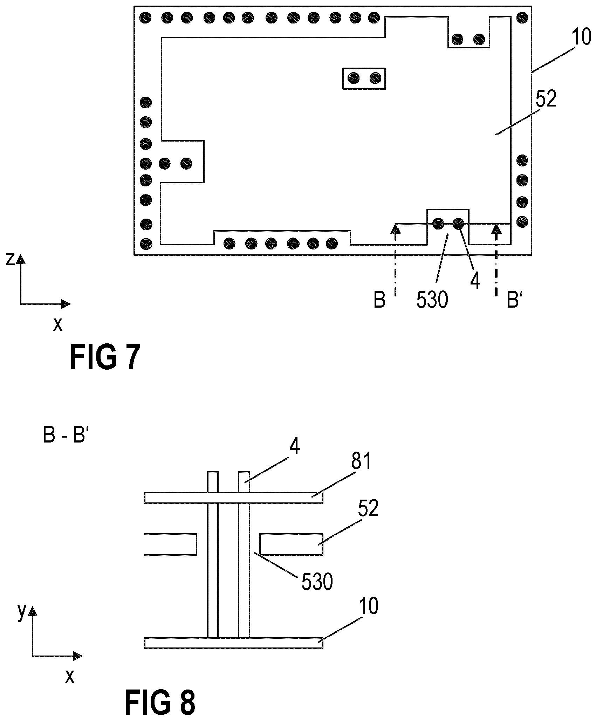

Now referring to Figure 7, it is also possible that the terminal elements 4 do not penetrate through the heat protective layer 52 at all. The heat protective layer 52 may have openings, recesses and/or projections in those areas where terminal elements 4 are arranged, for example. That is, each of the plurality of terminal elements 4 is arranged distant from the heat protective layer 52 in a horizontal direction x, z. This is also schematically illustrated in the cross-sectional view of Figure 8, which shows a cross-section along a section line B-B' of the arrangement illustrated in Figure 7. The heat protective layer 52 in this example may have an irregular shape, for example. The shape of the heat protective layer 52, however, depends on the positions of the terminal elements 4 on the substrate 10. For example, if terminal elements 4 are only arranged along the sidewalls of the housing 7, a rectangular or square shaped heat protective layer 52 may be arranged in the power semiconductor module arrangement.

The embodiment of Figures 5 and 6, however, may also be combined with the embodiment of Figures 7 and 8. That is, some terminal elements 4 may extend through the heat protective layer 52 similar to what has been described with respect to Figure 5 and 6, while other terminal elements 4 are arranged distant from the heat protective layer 52, similar to what has been described with respect to Figures 7 and 8.

As has been described above, the heat protective layer 52 may be an insert component or mat that is formed separately and inserted into the power semiconductor module arrangement 10. According to one example, the heat protective layer 52 may be inserted into the housing 7, before inserting the printed circuit board 81. The housing 7 may then be filled with the liquid material of the encapsulant 5, which is subsequently hardened.

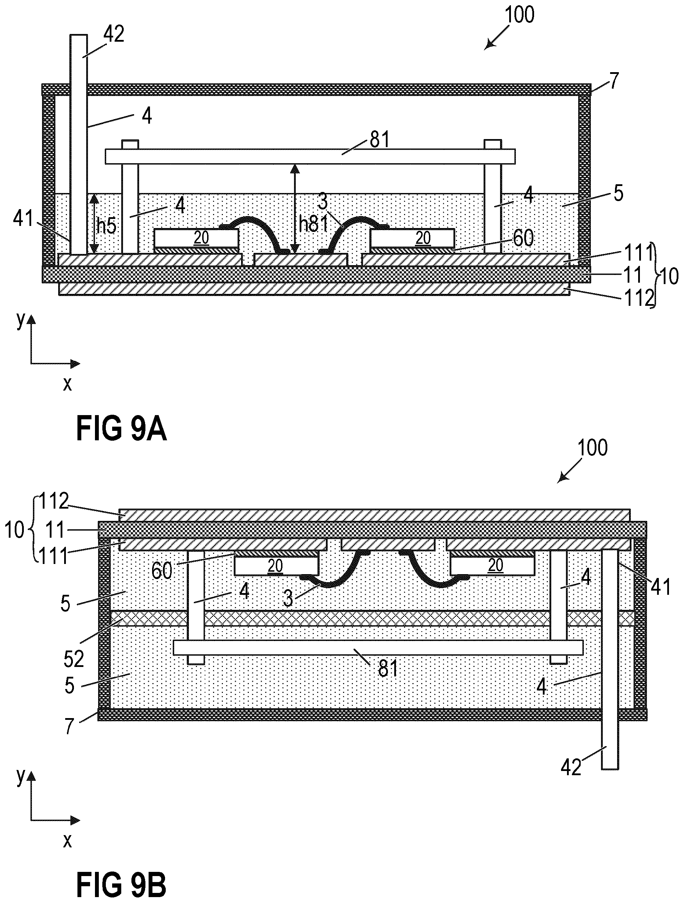

This, however, is only one example. The heat protective layer 52 may be formed in any other suitable way. An alternative method for forming a heat protective layer is illustrated in Figure 9. As is illustrated in Figure 9A, in a first step a material forming the encapsulant 5 may be filled into the housing 7, with the substrate 10 and the components mounted thereon arranged inside the housing 7. The material may be liquid when it is filled in the housing 7 and may subsequently be hardened. The encapsulant 5 covers the substrate 10 and the components mounted thereon. However, a height h5 of the encapsulant 5 from the substrate 10 in a vertical direction y is less than a distance h81 between the substrate 10 and the printed circuit board 81. That is, the encapsulant 5 does not cover or even contact the printed circuit board 81. The printed circuit board 81 may be inserted into the housing before or after forming the encapsulant 5. The power semiconductor module arrangement 100 may then be turned upside down, as is schematically illustrated in Figure 9B. Material forming the encapsulant 5 may again be filled into the housing in a similar fashion as has been described with respect to Figure 9A. However, as the arrangement is turned upside down, the material of the encapsulant 5 now covers a lid or top of the housing 7. The material of the encapsulant 5 may be filled into the housing 7 until it completely covers the printed circuit board 81. However, the cavity remaining in the housing 7 after the first step (Figure 9A) is not completely filled with the material of the encapsulant 5. In this way, a layer of air remains between the two different sections of encapsulant 5. This layer of air forms the heat protective layer 52. The material of the encapsulant 5 again may be liquid when it is filled in the housing 7, and may subsequently be hardened. In this example, due to the specific method for forming the heat protective layer 52, the heat protective layer 52 directly adjoins all sidewalls of the housing 7.

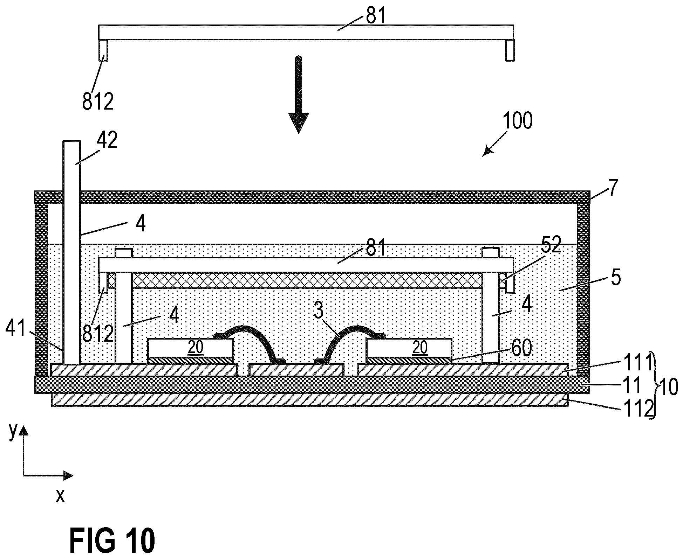

Now referring to Figure 10, an even further example of a method for forming the heat protective layer 52 is schematically illustrated. In this example, the printed circuit board 81 comprises protrusions 812. The protrusions 812 extend along the outer edge of the entire printed circuit board 81. The material of the encapsulant 5 may be first filled into the housing 7. While the material of the encapsulant 5 is still liquid, the printed circuit board 81 may be pressed into the material, with the protrusions 812 facing towards the substrate 10. The material of the encapsulant 5 does not completely drive out the air inside the cavity formed by the printed circuit board 81 and the protrusions 812, in a similar manner as when a drinking glass is inserted upside down in a bucket of water. Therefore, at least a thin layer of air remains below the printed circuit board 81. In this example, therefore, the resulting heat protective layer 52 may directly adjoin the printed circuit board 81 with a first side. The heat protective layer 52 further directly adjoins the encapsulant 5 with a second side opposite the first side, wherein the second side faces the substrate 10. Once the printed circuit board 81 has been inserted into the material of the encapsulant 5 and is brought into its final mounting position, the material of the encapsulant 5 may be hardened. The material of the encapsulant 5 may be hardened during a heating step, for example, during which liquid is evaporated from the encapsulant 5, resulting in a hardening of the material. In Figure 10, a printed circuit board 81 comprising protrusions 812 that has not yet been inserted into the power semiconductor module 100 is schematically illustrated for illustration purposes only in addition to a printed circuit board 81 arranged in its final mounting position.

## Claims

1. A power semiconductor module arrangement comprises,
a housing (7);
a substrate (10) arranged inside the housing (7);
a printed circuit board (81) arranged inside the housing (7) distant from and in parallel to the substrate (10);
an encapsulant (5) at least partly filling the interior of the housing (7), thereby covering the substrate (10) and the printed circuit board (81); and
a heat protective layer (52) arranged inside the housing (7) between the substrate (10) and the printed circuit board (81), and extending in a plane that is parallel to the substrate (10) and the printed circuit board (81), wherein a thermal resistance of the heat protective layer (52) is greater than a thermal resistance of the encapsulant (5).

2. The power semiconductor module arrangement of claim 1, wherein the heat protective layer (52) is arranged distant from the printed circuit board (81) and is fully embedded in the encapsulant (5).

3. The power semiconductor module arrangement of claim 1, wherein the heat protective layer (52)
directly adjoins the printed circuit board (81) with a first side, and
directly adjoins the encapsulant (5) with a second side opposite the first side,
wherein the second side faces the substrate (10).

4. The power semiconductor module arrangement of any of claims 1 to 3, wherein the heat protective layer (52) is formed by a cavity filled with air.

5. The power semiconductor module arrangement of claim 4, wherein the cavity is surrounded by a casing (520) comprising a material that is different from the material of the encapsulant (5).

6. The power semiconductor module arrangement of claim 5, wherein the cavity is partitioned into a plurality of separate chambers (54) by means of a plurality of dividing walls (524).

7. The power semiconductor module arrangement of claim 6, further comprising a plurality of terminal elements (4), wherein each of the plurality of terminal elements (4) extends from the substrate (10) to the printed circuit board (81) and through a different one of the plurality of chambers (54) of the heat protective layer (52).

8. The power semiconductor module arrangement of any of claims 1 to 4, further comprising a plurality of terminal elements (4), wherein
each of the plurality of terminal elements (4) extends from the substrate (10) to the printed circuit board (81); and
each of the plurality of terminal elements (4) is arranged distant from the heat protective layer (52).

9. The power semiconductor module arrangement of any of the preceding claims, further comprising at least one of:
at least one heat conduction element (90) coupled to the printed circuit board (81) with a first end, and to a first heat sink (14) with a second end, wherein the substrate (10) is arranged on the first heat sink (14), and the at least one heat conduction element (90) is configured to conduct heat away from the printed circuit board (81) to the first heat sink (14); and
at least one second heat sink (92) thermally coupled to the printed circuit board (81) and configured to conduct heat away from the printed circuit board (81), wherein the printed circuit board (81) is arranged between the at least one second heat sink (92) and the substrate (10).

10. The power semiconductor module arrangement of any of claims 1 to 3, wherein the heat protective layer (52) comprises a glass or plastic material.

11. The power semiconductor module arrangement of any of claims 1 to 3, wherein the heat protective layer (52) comprises a material and a plurality of particles or fillers distributed therein and having a higher thermal resistivity than the material of the encapsulant (5).

12. A method comprising:
arranging a substrate (10) in a housing (7);
arranging a heat protective layer (52) in the housing (7);
arranging a printed circuit board (81) in the housing (7) distant from and in parallel to the substrate (10); and
forming an encapsulant (5) at least partly filling the interior of the housing (7), thereby covering the substrate (10), the printed circuit board (81), and the heat protective layer (52), wherein
the heat protective layer (52) is arranged between the substrate (10) and the printed circuit board (81), and extends in a plane that is parallel to the substrate (10) and the printed circuit board (81), and
a thermal resistance of the heat protective layer (52) is greater than a thermal resistance of the encapsulant (5).

13. The method of claim 12, further comprising
forming the heat protective layer (52) as an insert component or mat prior to arranging the heat protective layer (52) in the housing (7).

14. A method comprising:
arranging a substrate (10) in a housing (7);
arranging a printed circuit board (81) in a housing (7), distant from and in parallel to the substrate (10);
filling a first material in the housing (7), thereby covering the substrate (10) and any components mounted thereon with the first material, wherein a height (h5) of the material from the substrate (10) in a vertical direction (y) is less than a distance (h81) between the substrate (10) and the printed circuit board (81);
hardening the first material, thereby forming a first section of an encapsulant (5);
turning the arrangement upside down;
filling the first material in the housing (7), thereby covering a top or lid of the housing (7) and the printed circuit board (81) with the first material, wherein the housing (7) is not completely filled with the first material such that a layer of air remains between the first section of the encapsulant (5) and the first material;
hardening the first material, thereby forming a second section of encapsulant (5), wherein
the layer of air between the two sections of encapsulant (5) forms a heat protective layer (52) having a thermal resistance that is greater than a thermal resistance of the encapsulants (5).

15. A method comprising:
arranging a substrate (10) in a housing (7);
filling a first material in the housing (7), thereby covering the substrate (10) and any components mounted thereon;
arranging a printed circuit board (81) in the housing (7), distant from and in parallel to the substrate (10), wherein the printed circuit board (81) comprises protrusions (812) extending along the edges of the printed circuit board (81), and wherein arranging the printed circuit board (81) in the housing (7) comprises pressing the printed circuit board (81) into the first material, with the protrusions (812) facing towards the substrate (10) such that a layer of air remains below the printed circuit board (81); and
hardening the first material, thereby forming an encapsulant (5), wherein
the layer of air below the printed circuit board (81) forms a heat protective layer (52) having a thermal resistance that is greater than a thermal resistance of the encapsulant (5).

## Amended claims

### Amended claims in accordance with Rule 137(2) EPC.

1. A power semiconductor module arrangement comprises,
a housing (7);
a substrate (10) forming a ground surface of or arranged inside the housing (7);
one or more semiconductor bodies (20) arranged on the substrate (10);
a printed circuit board (81) arranged inside the housing (7) distant from and in parallel to the substrate (10);
an encapsulant (5) at least partly filling the interior of the housing (7), thereby completely covering the substrate (10) with the one or more semiconductor bodies (20) arranged thereon and the printed circuit board (81); and
a heat protective layer (52) arranged inside the housing (7) between the substrate (10) and the printed circuit board (81), and extending in a plane that is parallel to the substrate (10) and the printed circuit board (81), wherein a thermal resistance of the heat protective layer (52) is greater than a thermal resistance of the encapsulant (5), and wherein the heat protective layer (52) is arranged distant from the printed circuit board (81) and is fully embedded in the encapsulant (5) and directly adjoins the encapsulant (5) on all sides.

2. The power semiconductor module arrangement of claim 1, wherein the heat protective layer (52)
directly adjoins the printed circuit board (81) with a first side, and
directly adjoins the encapsulant (5) with a second side opposite the first side, wherein the second side faces the substrate (10).

3. The power semiconductor module arrangement of any of claims 1 to 2, wherein the heat protective layer (52) is formed by a cavity filled with air.

4. The power semiconductor module arrangement of claim 3, wherein the cavity is surrounded by a casing (520) comprising a material that is different from the material of the encapsulant (5).

5. The power semiconductor module arrangement of claim 4, wherein the cavity is partitioned into a plurality of separate chambers (54) by means of a plurality of dividing walls (524).

6. The power semiconductor module arrangement of claim 5, further comprising a plurality of terminal elements (4), wherein each of the plurality of terminal elements (4) extends from the substrate (10) to the printed circuit board (81) and through a different one of the plurality of chambers (54) of the heat protective layer (52).

7. The power semiconductor module arrangement of any of claims 1 to 3, further comprising a plurality of terminal elements (4), wherein
each of the plurality of terminal elements (4) extends from the substrate (10) to the printed circuit board (81); and
each of the plurality of terminal elements (4) is arranged distant from the heat protective layer (52).

8. The power semiconductor module arrangement of any of the preceding claims, further comprising at least one of:
at least one heat conduction element (90) coupled to the printed circuit board (81) with a first end, and to a first heat sink (14) with a second end, wherein the substrate (10) is arranged on the first heat sink (14), and the at least one heat conduction element (90) is configured to conduct heat away from the printed circuit board (81) to the first heat sink (14); and
at least one second heat sink (92) thermally coupled to the printed circuit board (81) and configured to conduct heat away from the printed circuit board (81), wherein the printed circuit board (81) is arranged between the at least one second heat sink (92) and the substrate (10).

9. The power semiconductor module arrangement of any of claims 1 to 2, wherein the heat protective layer (52) comprises a glass or plastic material.

10. The power semiconductor module arrangement of any of claims 1 to 2, wherein the heat protective layer (52) comprises a material and a plurality of particles or fillers distributed therein and having a higher thermal resistivity than the material of the encapsulant (5).

11. A method comprising:
arranging a substrate (10) with one or more semiconductor bodies (20) arranged thereon in a housing (7) or arranging a substrate (10) with one or more semiconductor bodies (20) arranged thereon to form a ground surface of a housing (7);
arranging a heat protective layer (52) in the housing (7);
arranging a printed circuit board (81) in the housing (7) distant from and in parallel to the substrate (10); and
forming an encapsulant (5) at least partly filling the interior of the housing (7), thereby completely covering the substrate (10) with the one or more semiconductor bodies (20) arranged thereon, the printed circuit board (81), and the heat protective layer (52), wherein
the heat protective layer (52) is arranged between the substrate (10) and the printed circuit board (81), and extends in a plane that is parallel to the substrate (10) and the printed circuit board (81),
a thermal resistance of the heat protective layer (52) is greater than a thermal resistance of the encapsulant (5), and
the heat protective layer (52) is arranged distant from the printed circuit board (81) and is fully embedded in the encapsulant (5) and directly adjoins the encapsulant (5) on all sides.

12. The method of claim 11, further comprising
forming the heat protective layer (52) as an insert component or mat prior to arranging the heat protective layer (52) in the housing (7).
